# EUROPEAN PATENT APPLICATION

(11) **EP 2 605 031 A1**
(43) Date of publication of application: **19.06.2013**
(21) Application number: 11867103.1
(22) Date of filing: 12.10.2011
(51) Int. Cl.: G01R 35/04

(54) **INTEGRATED MECHANISM FOR EXECUTING DETECTION ON ELECTRICITY CONSUMPTION INFORMATION ACQUISITION TERMINAL**

(71) Applicant: North China Grid Company Limited Center of Metrology, No. 1 NanXing Street, Hsinchuang XiCheng District Beijing 100045 (CN); Hangzhou Houda Automatic System Co., Ltd., Yuhang District Hangzhou City Zhejiang 310023 (CN); State Grid Corporation of China, Beijing 100031 (CN)
(72) Inventor: SONG, Wei, Beijing 100045 (CN); CHEN, Linsheng, Zhejiang 310023 (CN); WANG, Sitong, Beijing 100045 (CN); Yi, Zhonglin, Beijing 100045 (CN); WAN, Rongchun, Zhejiang 310023 (CN); XU, Zhanhe, Beijing 100045 (CN); YUAN, Ruiming, Beijing 100045 (CN); LU, Guanna, Beijing 100045 (CN); ZHANG, Luhua, Beijing 100045 (CN)
(74) Representative: Bettinger Schneider Schramm
(86) International application number: PCT/CN2011/080672
(87) International publication number: WO 2013/053110

(57) **Abstract**

It is disclosed that an integrated testing apparatus for electric meter being characterized in that it includes a main mounting plate at the four corners of which an inner cover opening hook, a SIM card crimping terminal, an cover opening device, and a network registered jack plugging device being disposed respectively, and at the centre of which a RS232 plug gripping device being disposed. The present invention achieves various actions such as gripping, plugging in and out, rotation or transposition by integrating the inner cover opening hook, the SIM card crimping terminal, the cover opening device, and the network registered jack plugging device, RS232 plug gripper within a main mounting plate, and utilizing the 3-dimensional motion of the manipulator, as well as auxiliary locating by visual locating device, which promotes operation for testing the channels of an electric meter using an entity apparatus with its simple structure, lower cost and high efficiency.

## Description

### TECHNICAL FIELD

The present invention relates generally to an testing apparatus cooperated with a manipulator.

### BACKGROUND OF THE INVENTION

In the assembling procedure of an electric meter, a series of operations needs to be done by inserting the RS232 plug and shielded antenna plug, opening SIM card cover, crimping SIM card terminals, opening the outer cover of electric meter, and inserting a registered jack into corresponding port of the electric meter. The series of operations in prior art are generally accomplished on the assembly line by manual working, which in turn increases the manufacturing cost.

### SUMMARY

The present invention is to address those aforementioned problems, providing for an integrated testing apparatus for meter reading system to accomplish a series of operations with its simple structure, lower cost and high efficiency.

For resolving those problems, the present invention implies to provide for an integrated testing apparatus with multifunctionality which being characterized in that it includes a main mounting plate at the four corners of which an inner cover opening hook, a SIM card crimping terminal, an cover opening device, and a network registered jack plugging device being disposed respectively, and at the centre of which a RS232 plug gripping device being disposed.

According to an preferred aspect of the invention, the RS232 plug gripper includes a pair of gripper jaws leveraged connecting to a gripper arm disposed onto the main mounting plate, wherein a gripper hole being formed by head portions of the gripper jaws, and a compression spring being disposed between said two gripper jaws to generally keep the gripper jaws open, as well as an air cylinder being disposed behind rear portions of the gripper jaws to close the gripper jaws up by motivating a guiderod stretching out and drawing back.

According to an preferred embodiment of the invention, the rear portions of the gripper jaws are coupled to form a V-shape opening, the air cylinder is disposed within the gripper arm to motivate the guiderod stretching out and drawing back, wherein an arrowhead portion corresponding to the V-shape opening is disposed at the head portion of the guiderod, wherein the guiderod motivates the gripper jaws closing up, and the air cylinder is configured to being controlled by an external control application.

According to an preferred embodiment of the invention, an image processing and locating device is disposed on the main mounting plate, wherein the image processing and locating device comprises visual locating device, and an optical source cooperating with the visual locating device is further disposed on the main mounting plate.

According to an preferred embodiment of the invention, the cover opening device includes an cover opening suck disc in which inner vacuum is generated by an external vacuum generator and which is controlled by an external control application.

According to an preferred embodiment of the invention, the inner cover opening hook, the SIM card crimping terminal, the cover opening device, and the network registered jack plugging device being disposed at the four corner of the main mounting plate in clockwise direction.

According to a preferred embodiment of the invention, one portion of the main mounting plate is disposed of the RS232 plug gripper, another portion of the main mounting plate is disposed of the optical source, visual locating device and connects with a manipulator.

The preferred embodiment of the present invention achieves various actions such as gripping, plugging in and out, rotation or transposition by integrating an inner cover opening hook, a SIM card crimping terminal, an cover opening device, and a network registered jack plugging device, RS232 plug gripper within a main mounting plate, and utilizing the 3-dimensional motion of the manipulator, as well as auxiliary locating by visual locating device, which promotes operation for testing the channels of an electric meter using an entity apparatus with its simple structure, lower cost and high efficiency.

The above described features and advantages, as well as others, will become more readily apparent to the skilled in the art by reference to the following description and accompanying drawings.

### BRIEF DESCRIPTION OF THE DRAWINGS

FIG.1 shows a representative plan view of the invention;

FIG.2 shows a representative cutaway view of the invention.

### DETAILED DESCRIPTION OF THE PREFERRED EMBODIMENTS

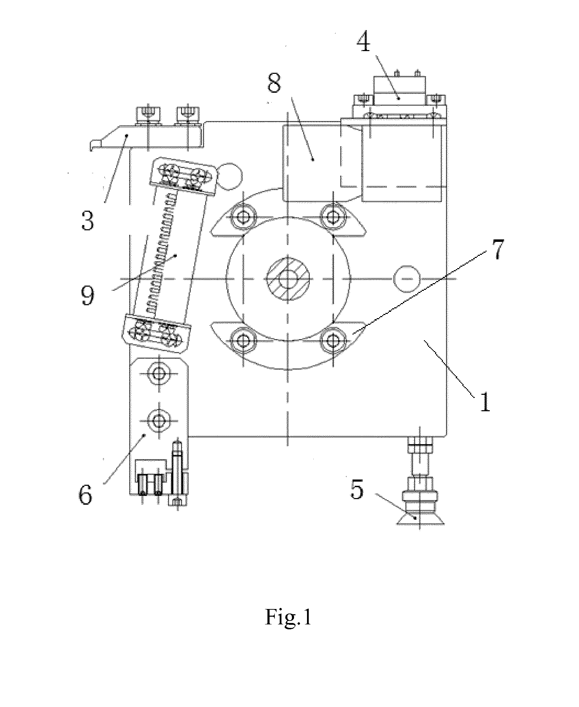

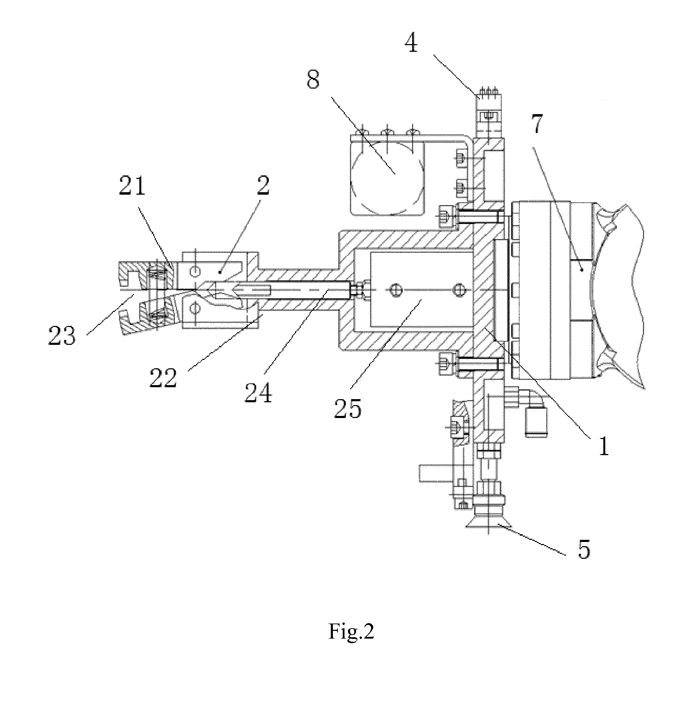

Referring now to Fig.1 and 2, a preferred embodiment of the integrated testing apparatus of meter reading system of the present invention includes a main mounting plate 1 at the four corners of which an inner cover opening hook 3, a SIM card crimping terminal 4, an cover opening device 5, and a network registered jack plugging device 6 being disposed respectively, at the centre of which a RS232 plug gripping device 2 being disposed. A manipulator connects with the main mounting plate 1 to control the 3-dimensional motion of the main mounting plate, further the inner cover opening hook 3, the SIM card crimping terminal 4, the cover opening device 5, and the network registered jack plugging device 6. The main mounting plate further includes an image processing and locating device thereon for receiving the accurate location of the manipulator. The RS232 plug gripper includes a pair of gripper jaw 21 which leveraged connecting to a gripper arm 22 disposed onto the main mounting plate 1, wherein a gripper hole 23 being formed by head portions of the gripper jaws 21, and a compression spring being disposed between the two gripper jaws to generally keep the gripper jaws open, as well as an air cylinder being disposed behind rears portion of the gripper jaws to close the gripper jaws up by motivating a guiderod stretching out and drawing back.
The rear portions of the gripper jaws are coupled to form a V-shape opening, the air cylinder 25 is disposed within the gripper arm to motivate the guiderod 24 stretching out and drawing back, wherein an arrowhead portion corresponding to the V-shape opening is disposed at the head portion of the guiderod, the guiderod motivates the gripper jaws closing up, and the air cylinder is configured to being controlled by an external control application. The image processing and locating device comprises a visual locating device 8, and an optical source 9 cooperating with the visual locating device 8 is further disposed on the main mounting plate. The cover opening device 5 includes an cover opening suck disc in which inner vacuum is generated by an external vacuum generator and which is controlled by an external control application. One portion of the main mounting plate is disposed of the RS232 plug gripper 2, another portion of the main mounting plate is disposed of the optical source, visual locating device and connects with the manipulator 7.

1. Testing apparatus cooperated with a manipulator comprising a RS232 plug gripper, an inner cover opening hook, a SIM card crimping terminal, an cover opening suck disc, a network registered jack plugging device and an optical source integrated thereon connects with the manipulator.

2. Various kinds of action such as gripping, plugging in and out, rotation or transposition are achieved by utilizing the 3-dimensional motion of the manipulator, as well as auxiliarily locating by visual locating device.

3. The RS232 plug gripper as illustrated in the fig.1 and 2 is mainly configured to clamp RS232 plug and shielded antenna plug in use of motivating a pair of gripper jaw stretching out and drawing back by the air cylinder and spring. RS232 plug gripper on work is vertically downward, and the head portion of the pair of gripper jaws maintains opened and orients in particular direction, bodily moving to align with the corresponding RS232 plug of an electric meter on work stock and then moving downwards to an appropriate height, motivating the air cylinder to stretch out a slant of the guiderod so that push a slant of the gripper jaws, and then rotating the gripper jaws with its fulcrum that is closing up the head portion of the gripper jaws to clamp the RS232 plug out by bodily moving upwards to another appropriate height actuated by the manipulator, bodily moving to align with the corresponding RS232 port of the electric meter to vertically plug the RS232 plug therein, and then motivating the air cylinder to draw back the cylinder, and opening the head portions of the gripper jaws by the stretching force of the compression spring therebetween.

4. The inner cover opening hook as illustrated in the fig.1 and 2 is mainly configured to open SIM card cover (inner cover) for mating the SIM card crimping terminal with its corresponding SIM card contact. Meanwhile, the inner cover opening hook is configured to apply for various shape of concentrator or meter. The inner cover opening hook is configured to open the inner cover by rotating the testing apparatus to make the hook vertically downward and orient it in particular direction, bodily moving above on the inner cover lock of the electric meter to align with it and then moving downwards to an appropriate height, horizontally moving the hook towards to rotation fulcrum of the inner cover to unlock the inner cover lock, as well as hooking the inner cover by using a head portion of the hook and bodily rotating the testing apparatus.

5. The visual locating device as illustrated in the fig.1 and 2 is mainly configured for accurate location for capturing photos, analysis with software therein and automatically identifying the features, in turn guaranteeing the reliability and accuracy for various actions. Adjusting the location of the manipulator promptly can be achieved by captured features.

6. The SIM card crimping terminal as illustrated in the fig.1 and 2 is mainly configured to be aligned with the SIM card contact by rotating and adjusting the testing apparatus to make the SIM card crimping terminal downward, and then moving the testing apparatus downwards to an appropriate height to contact the terminal with the contact. The testing apparatus can be rise up after accomplishing testing.

7. The cover opening suck disc as illustrated in the fig.1 and 2 is mainly configured to open the outer cover by rotating the testing apparatus to make the cover opening suck disc downward, moving the testing apparatus to contact with the corresponding portion of the outer cover of electric meter, and sorption the outer cover as vacuum generator is automatically activated, as well as rotating the testing apparatus with its center. The vacuum can be removed after opening the outer cover.

8. The network registered jack plugging device as illustrated in the fig.1 and 2 is configured to have a crystal head, which is aligned with the corresponding network port by rotating the testing apparatus to be downward and inserted into the network port by moving the testing apparatus in horizontal direction, and pulled out by moving the testing apparatus in negative direction after accomplishing testing.

9. The optical source as illustrated in the fig.1 and 2 is mainly configured to cooperate with the aforementioned visual locating device for receiving clear visual pictures which in turn for locating accuracy.

## Claims

1. An integrated testing apparatus for electric meter, which being **characterized in that** it includes a main mounting plate (1) at the four corners of which an inner cover opening hook (3), a SIM card crimping terminal (4), an cover opening device (5), and a network registered jack plugging device (6) being disposed respectively, and at the centre of which a RS232 plug gripping device (2) being disposed.

2. The integrated testing apparatus for electric meter of claim 1, wherein the RS232 plug gripper includes a pair of gripper jaws (21) leveraged connecting to a gripper arm (22) disposed onto the main mounting plate, wherein a gripper hole (23) being formed by head portions of the gripper jaws, and a compression spring being disposed between said two gripper jaws to generally keep the gripper jaws open, as well as an air cylinder (25) being disposed behind rear portions of the gripper jaws to close the gripper jaws up by motivating a guiderod (24) stretching out and drawing back.

3. The integrated testing apparatus for electric meter of claim 2, wherein the rear portions of the gripper jaws (21) are coupled to form a V-shape opening, the air cylinder (24) is disposed within the gripper arm to motivate the guiderod (24) stretching out and drawing back, wherein an arrowhead portion corresponding to said V-shape opening is disposed at the head portion of the guiderod (24), the guiderod motivates the gripper jaws closing up, and the air cylinder (25) is configured to being controlled by an external control application.

4. The integrated testing apparatus for electric meter of any one of claim 1 to 3, wherein an image processing and locating device is disposed on the main mounting plate, wherein the image processing and locating device comprises visual locating device (8), and an optical source (9) cooperating with the visual locating device is further disposed on the main mounting plate (1).

5. The integrated testing apparatus for electric meter of claim 4, wherein the cover opening device (5) includes a cover opening suck disc in which inner vacuum is generated by an external vacuum generator and which is controlled by an external control application.

6. The integrated testing apparatus for electric meter of claim 5, wherein the inner cover opening hook (3), the SIM card crimping terminal (4), the cover opening suck disc (5), and the network registered jack plugging device (6) being disposed in clockwise direction at the four corner of the main mounting plate (1).

7. The integrated testing apparatus for electric meter of claim 1, wherein one portion of the main mounting plate (1) is disposed of the RS232 plug gripper (2), another portion of the main mounting plate is disposed of the optical source (9), visual locating device (8) and connects with a manipulator (7).
